(19) Europäisches Patentamt
European Patent Office
Office européen des brevets

(11)  **EP 2 637 311 B1**

(12)  **EUROPEAN PATENT SPECIFICATION**

(45) Date of publication and mention
of the grant of the patent:
**07.12.2016 Bulletin 2016/49**

(51) Int Cl.:
*H04B 1/30* (2006.01)     *H03D 3/00* (2006.01)
*H04L 25/06* (2006.01)

(21) Application number: **12158582.2**

(22) Date of filing: **08.03.2012**

(54) **Algorithm for raw rf transceiver dc offset calibration**

Algorithmus mit HF-Sender-Empfänger Gleichstrom-Offset-Kalibrierung

Algorithme pour l'étalonnage brut du décalage CC d'un émetteur-récepteur RF

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**11.09.2013 Bulletin 2013/37**

(73) Proprietor: **Intel Deutschland GmbH
85579 Neubiberg (DE)**

(72) Inventors:
• **Nitsche, Gunnar
01445 Radebeul (DE)**

• **Müller, Peter
01279 Dresden (DE)**

(74) Representative: **Lippert, Stachow & Partner
Patentanwälte
Krenkelstrasse 3
01309 Dresden (DE)**

(56) References cited:
**US-A1- 2002 094 792     US-A1- 2005 221 781
US-A1- 2006 077 003     US-A1- 2006 222 117
US-A1- 2007 153 945     US-A1- 2007 184 803**

**Description**

Technical Field

The present invention relates to a method for compensating DC offset in RF transceivers. The present invention specifically relates to a method for performing raw DC offset compensation.

Prior Art

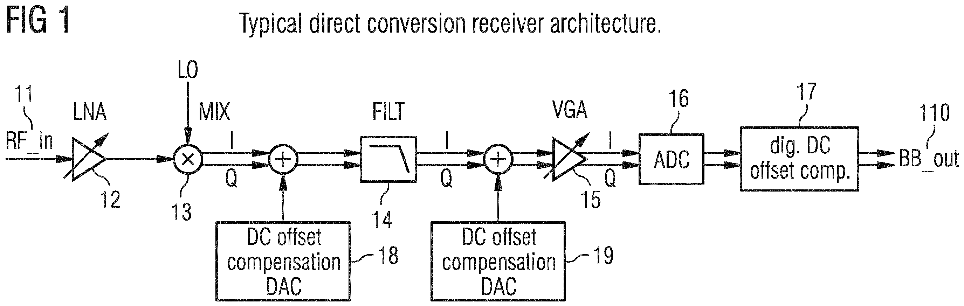

Integrated direct conversion RF transceiver architectures became popular in the last decade for many different RF applications. They require a minimal set of building blocks, see Fig. 1. Each RX or TX signal path requires only one mixer with associated local oscillator which also simplifies the synthesizer. An IF filter is no longer needed.

But this architecture has also drawbacks. DC offset is introduced by the individual transceiver/receiver components like amplifier, mixer, filter etc. It may distort the signal, and directly limits the available dynamic range. Strong offsets can saturate the signal path or detoriate the digital signal processing performance. It became common to compensate this DC offset by adding DC voltages opposite to the occurring DC offset. Several different solutions have been developed in the past.

One typical approach is providing additional hardware blocks as disclosed in US 6,756,924 B2 or US 7,271,649 B2 or Tanaka, T. Yamawaki, K. Takikawa, N. Hayashi, I. Ohno, T.Wakuta, S. Takahashi, M. Kasahara, and B. Henshaw, "GSM/DCS1800 Dual Band Direct-Conversion Transceiver IC With a DC Offset Calibration System," in 01 ESSCIRC Session 3.3, 2001. These blocks are typically dedicated to individual building blocks. The DC offset is measured and compensated. This approach requires additional elements not only for compensation, e.g. DACs, but also for measuring the DC offset and for determining the value needed for compensation. These blocks are running permanently. They increase the system complexity and consume additional power and space.

Other approaches determine the DC offset and the resulting DC compensation values permanently in the digital domain as disclosed in Marko Mailand and Hans-Joachim Jentschel, "Compensation of DC-Offsets and RF-Self-Mixing Products in Six-Port-Based Analog Direct Receivers," in 14th IST Mobile & Wireless Communication Summit, Dresden, June 2005; or Russell Hoppenstein, "DC Offset Auto-Calibration of TRF371x," Texas Instruments, 2010; or I.-H. Sohn, E.-R. Jeong, and Y. H. Lee, "Data-Aided Approach to I/Q Mismatch and DC Offset Compensation in Communication Receivers," IEEE COMMUNICATIONS LETTERS, vol. 6, no. 12, December 2002. The compensation values are introduced by a DAC in the analog section. But this concept prepares only one set of compensation values. This is working well if the system gain is fixed. But systems with variable gain make the DC offset variable as well. Therefore every new gain configuration requires new DC offset values to be measured and new compensation values to be set. This increases the steps to be done to change the gain as additional calibration steps must be executed as well for every new gain setting. Setting the gain becomes more complex and time consuming.

Fig. 1 shows a state-of-the art direct conversion receiver comprising a plurality of components like low noise amplifier 12, mixer 13, filter 14, VGA 15, ADC 16, digital DC offset compensation 17 between radio frequency (RF) input 11 and baseband (BB) output 110. Direct conversion RF transceivers, e.g. for WLAN, did use more than one point to enter DC compensation voltages by additional DACs 18, 19. These DC compensation voltages (the calibration parameters) were typically determined from different measurements and from calculations in the digital domain, e.g. by a signal processor. It is common to add short cut and bypass switches to the individual transceiver/receiver components to measure the DC offset that occurs at each individual stage separately. Therefore, some of the components were operated under debug/test conditions (bypass or short cut mode) instead of the real operation conditions while the DC offset is measured. This introduces additional errors, e.g. due to different bias or temperature conditions, and increases the system complexity.

It is generally intended to find a set of calibration parameters that covers the complete gain control range. But this is not common in present implementations as the accuracy of the determined calibration parameters is insufficient. Therefore, the complete gain control range is split into several different sub ranges. Each different sub range has an own set of set of calibration parameters. Changing the gain from one sub range to another requires also the calibration parameters to be changed which is still complex and time consuming. US 2007/0184803 A1 a calibration is performed by sequentially calibrating each variable amplifier in an amplifier chain.

The transceiver (Rx path) with DC offset sources and compensation DACs (digital to analog converters) given in Fig. 1, can be simplified, see Fig.2, to a set of variable gain stages 23 corresponding to mixer 13, 24 corresponding to filter 14, 25 corresponding to VGA 15 between RF input 21 and BB output 210, where the DC offset 211, 212, 213 and the compensation DACs 28 and 29 are connected to the input of each individual stage. The mathematical expression of this simplified model is given in Fig.3 comprising a plurality of gain stages 321,...,32k,...,32n, DC offsets 330,331,...,33k,...33n and compensation DACs 320,321,...,32k,...,32n between RF input 31 and BB output 35.

The compensation DACs are connected to the signal path, Fig.1. Each DAC adds a DC voltage that is opposite to the DC offset at this point so that the total DC becomes close to zero. This remaining nonzero DC voltage becomes amplified by the gain stages that follow. As this gain is variable the resulting DC offset at the output of said signal path directly depends on the following total gain and the DC offset residual:

$$mean(BB_{out}) = \sum_{k=1}^{n} \left[ A_{tot,k} \times \left[ DC_{off,k} + DC_{comp,k} \right] \right]$$

The total gain for the gain stage k (k>0) is given by:

$$A_{tot,k} = \prod_{j=1}^{k} A_{j,i}$$

Therefore, a good calibration algorithm should find values $DC_{comp,k}$ that meet the relation:

$$0 \approx DC_{off,k} + DC_{comp,k}$$

The essential part of the calibration routines is therefore to determine $DC_{off,k}$ accurately from different measured mean ($BB_{out}$) values so that

$$DC_{comp,k} = -DC_{off,k}$$

Throughout this document the following notation will be used:

| | |
|---|---|
| number of total gain stages: | n |
| DC offset of gain stage k: | $DC_{off,k}$ |
| DC compensation parameter of gain stage k: | $DC_{comp,k}$ |
| DC offset residual of gain stage k: | $DC_{off,k}+DC_{comp,k}$ |
| gain control range R of gain stage k: | $A_{k,R}$ |
| gain i of stage k, were $A_{k,i}$ element of $A_{k,R}$: | $A_{k,i}$ |
| total gain for gain stage k: | $A_{tot,k}$ |
| DC offset residual at ADC output (BB_out): | $DC_{res}$ |

Disclosure of the Invention

It is therefore an objective of the present invention to provide a method for compensating DC offset in radio frequency transceiver architectures having an improved efficiency. It is specifically an objective of the present invention to provide an improved DC offset calibration method for RF transceivers with variable gain that provide multiple points with compensation DACs (digital to analog converters) for DC offset compensation.

This objective is achieved by a method according to the independent claim. Dependent claims relate to further aspects of the present invention.

The present invention relates to a method for compensating DC offset in a signal path comprising a plurality of stages arranged in a chain forming a signal path, each stage k having an individual gain $A_k$ and an associated total gain $A_{tot,k}$ that is the product of the gains of all preceding stages and the gain of said stage: $A_{tot,k}=A_k*A_{tot,k-1}$.

For each stage a DC calibration is performed by introducing a DC compensation signal $DC_{comp,k}$ by means of an compensation digital to analog converter that is electrically coupled to said stage and that is configured to add the DC compensation signal to the DC offset of said stage.

The raw DC compensation is performed stage by stage starting with the stage that is closest to the output of said signal path. Said raw DC compensation signal for said stage is determined by performing measuring a DC offset residual at the output of said
signal path,

setting the raw DC compensation signal to a value that
is the negative of the DC offset residual divided by the
total gain of said stage, wherein the total gain of said stage is the product of the gains of all preceding stages and the gain of said stage.

The DC compensation signal of gain stage k, $DC_{comp,k}$ can be calculated from the known total gain $A_{tot,k}$ and the measured DC offset residual $DC_{res}$ by the formula:

$$DC_{comp,k,m} = DC_{comp,k,m-1} - \frac{DC_{RES,m}}{A_{tot,k}}$$

where $DC_{comp,k,m}=0$.

The DC calibration is performed iteratively by determining the DC compensation signals for m calibration iterations for each stage, wherein m is positive integer.

One aspect of the raw DC calibration relates to the selection of the total gain $A_{tot,k}$ of each gain stage. It is preferably selected to be approximately in the middle between its minimum and maximum:

$$A_{tot,k} \approx \frac{A_{tot,k,max} - A_{tot,k,min}}{2}$$

As the total gain of a stage is dependent on the gain of said stage and the gains of all preceding stages, this implies setting the individual gain of each stage to an arithmetic mean of a maximum individual gain of said stage and a minimum individual gain of said stage.

The DC calibration increases the stability of the calibration process so that a calibration procedure comprising a possibly further refined DC calibration works for huge DC offsets. The computed calibration coefficients are good enough to prevent the system from saturation while a further refined DC calibration is performed.

It is an advantage of the present invention that only DC offset compensation elements, e.g. DACs that are common in present RF transceivers are required.

Brief Description of the Drawings

The method according to the invention is described in more detail herein below by way of exemplary embodiments and with reference to the attached drawings, in which:

Fig.1    shows a state-of-the-art direct conversion receiver architecture,

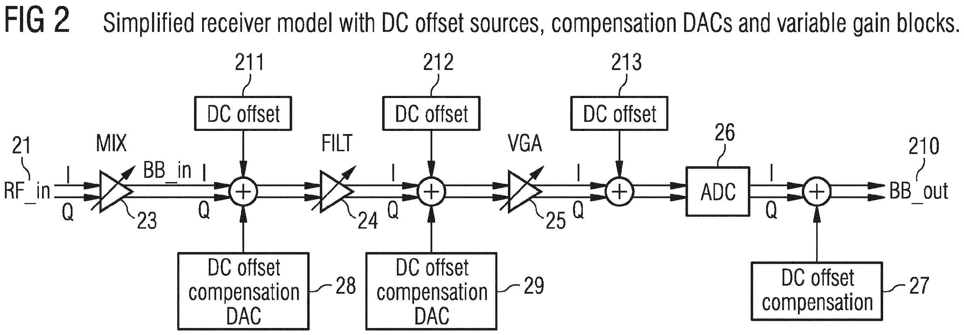

Fig.2    shows a simplified receiver model,

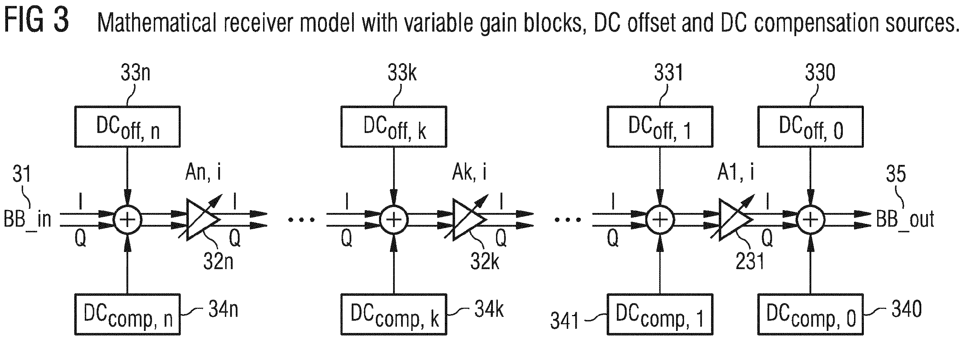

Fig.3    shows mathematical receiver model, and

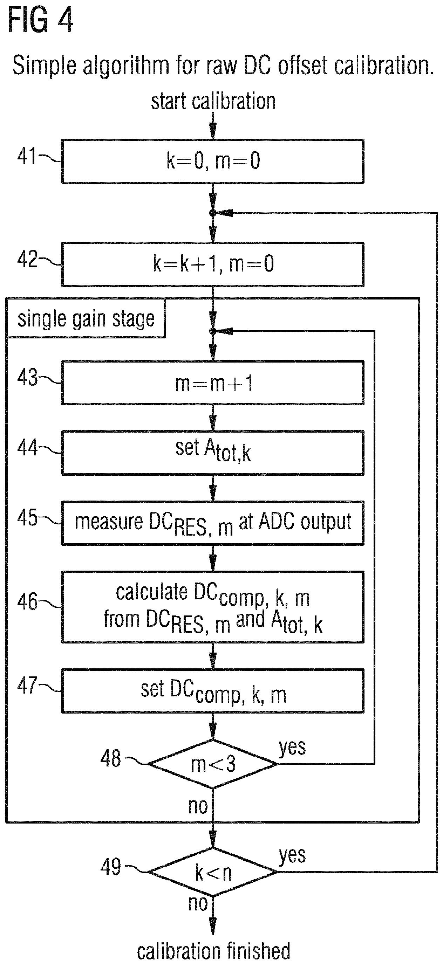

Fig.4    shows flow chart of the raw DC offset calibration algorithm.

Embodiments of the Invention

Fig. 4 shows a flow chart of an embodiment of the DC compensation algorithm. In step 41 the algorithm is initialized by setting the stage index and the calibration iteration index to zero. The outer loop comprising steps 42 to 49 refers to the computation of DC offset compensation signals for all stages. In step 42 the stage index k is incremented by one. In step 49 the outer loop is left in case all stages have been computed. The inner loop comprising steps 43 to 48 refers to the computation of DC compensation signals for a single stage k. In step 43 the calibration index m is incremented by one. In step 44 the total gain of stage k is set as computational variable used for computing the DC offset residual. In step 45 the resulting DC offset residual $DC_{RES,m}$ is measured. In step 46 the DC compensation signal $DC_{comp,k,m}$ is computed. In step 47 the DC compensation signal $DC_{comp,k,m}$ is set. The inner loop is executed three times according to step 48.

While the invention has been illustrated and described in detail in the drawings and foregoing description, such illustration and description are to be considered illustrative or exemplary and not restrictive. It will be understood that changes and modifications may be made by those of ordinary skill within the scope of the following claims.

**Claims**

1. Method for compensating DC offset in a signal path comprising a plurality of stages (k, n) arranged in a chain forming a signal path, each stage having an individual gain;

   wherein for each stage (k, n) a DC compensation is performed by introducing a DC compensation signal (340...34k...34n) by means of an compensation digital to analog converter that is electrically coupled to said stage and that is configured to add the DC compensation signal to the DC offset of said stage (k, n);

   wherein the DC compensation is performed stage by stage starting with the stage that is closest to the output (35) of said signal path; wherein a DC compensation algorithm comprising an outer loop (42 - 49) and an inner loop (43 - 48), wherein the outer loop performs the initializing of the algorithm and computing the DC offset compensation signals for all stages,

   wherein said DC compensation signal for said stage is determined by the inner loop comprising the steps:

   measuring a DC offset residual $DC_{RES,m}$ at the output of said signal path,

   setting the DC compensation signal to a value that is the negative of the DC offset residual divided by a total gain of said stage $A_{tot,k}$, wherein the total gain of said stage is the product of the individual gains of all preceding stages and the gain of said stage; and

   repeating the measuring of the DC offset residual and the setting the DC compensation signal within the inner loop.

2. Method according to claim 1, the method further comprising:

   setting the individual gain of each stage (k, n) to an arithmetic mean of a maximum individual gain of said stage and a minimum individual gain of said stage so that the total gain of said stage is an arithmetic mean of a maximum total gain of said stage and a minimum total gain of said stage.

**Patentansprüche**

1. Verfahren zum Kompensieren von Gleichstromoffset in einem Signalpfad, der mehrere Stufen (k, n) umfasst, die in einer einen Signalpfad bildenden Kette angeordnet sind, wobei jede Stufe einen individuellen Verstärkungsfaktor aufweist;

   wobei für jede Stufe (k, n) eine Gleichstromkompensation durchgeführt wird durch Einführen eines Gleichstrom-Kompensationssignals (340...34k...34n) mittels eines Kompensations-Digital-Analog-Umsetzers, der elektrisch mit der Stufe gekoppelt ist und der dafür ausgelegt ist, das Gleichstrom-Kompensationssignal zu dem Gleichstromoffset der Stufe (k, n) zu addieren;

   wobei die Gleichstromkompensation stufenweise beginnend mit der Stufe, die dem Ausgang (35) des Signalpfads am nächsten ist, durchgeführt wird; wobei ein Gleichstrom-Kompensationsalgorithmus eine äußere Schleife (42 - 49) und eine innere Schleife (43 - 48) umfasst, wobei die äußere Schleife die Initialisierung des Algorithmus und Berechnung der Gleichstrom-Offsetkompensationssignale für alle Stufen durchführt,

   wobei das Gleichstrom-Kompensationssignal für die Stufe durch die innere Schleife bestimmt wird, mit den folgenden Schritten:

   Messen eines Gleichstrom-Offset-Rests $DC_{RES,m}$ am Ausgang des Signalpfads,
   Setzen des Gleichstrom-Kompensationssignals auf einen Wert, der das Negative des Gleichstrom-Offset-Rests, dividiert durch einen Gesamtverstärkungsfaktor der Stufe $A_{tot,k}$, ist, wobei der Gesamtverstärkungsfaktor der Stufe das Produkt der individuellen Verstärkungsfaktoren aller vorhergehenden Stufen und des Verstärkungsfaktors der Stufe ist; und
   Wiederholen des Messens des Gleichstrom-Offsetrests und des Setzens des Gleichstrom-Kompensationssignals in der inneren Schleife.

2. Verfahren nach Anspruch 1, wobei das Verfahren ferner Folgendes umfasst:

   Setzen des individuellen Verstärkungsfaktors jeder Stufe (k, n) auf einen arithmetischen Mittelwert eines maximalen individuellen Verstärkungsfaktors der Stufe und eines minimalen individuellen Verstärkungsfaktors der Stufe dergestalt, dass der Gesamtverstärkungsfaktor der Stufe ein arithmetischer Mittelwert eines maximalen Gesamtverstärkungsfaktors der Stufe und eines minimalen Gesamtverstärkungsfaktors der Stufe ist.

**Revendications**

1. Procédé de compensation du décalage CC dans un trajet de signal comprenant une pluralité d'étages (k, n) disposés en chaîne formant un trajet de signal, chaque étage ayant un gain individuel ; une compensation CC étant effectuée pour chaque étage (k, n) en introduisant un signal de compensation CC (340...34k...34n) au moyen d'un convertisseur numérique-analogique de compensation qui est couplé électriquement audit étage et qui est configuré pour ajouter le signal de compensation CC au décalage CC dudit étage (k, n) ;

la compensation CC étant effectuée étage par étage en commençant par l'étage qui est le plus proche de la sortie (35) dudit trajet de signal ; un algorithme de compensation CC comprenant une boucle externe (42 - 49) et une boucle interne (43

- 48), la boucle externe effectuant l'initialisation de l'algorithme et calculant les signaux de compensation de décalage CC pour tous les étages,

ledit signal de compensation CC pour ledit étage étant déterminé par la boucle interne, comprenant les étapes suivantes :

mesurer un décalage CC résiduel $DC_{RES,m}$ à la sortie dudit trajet de signal,

fixer le signal de compensation CC à une valeur qui est le négatif du décalage CC résiduel divisé par un gain total dudit étage $A_{tot,k}$, le gain total dudit étage étant le produit des gains individuels de tous les étages précédents et du gain dudit étage ; et

répéter la mesure du décalage CC résiduel et la fixation du signal de compensation CC à l'intérieur de la boucle interne.

2. Procédé selon la revendication 1, le procédé comprenant en outre :

fixer le gain individuel de chaque étage (k, n) à une moyenne arithmétique d'un gain individuel maximal dudit étage et d'un gain individuel minimal dudit étage de telle sorte que le gain total dudit étage soit une moyenne arithmétique d'un gain total maximal dudit étage et d'un gain total minimal dudit étage.

FIG 1        Typical direct conversion receiver architecture.

EP 2 637 311 B1

**FIG 2** Simplified receiver model with DC offset sources, compensation DACs and variable gain blocks.

FIG 3    Mathematical receiver model with variable gain blocks, DC offset and DC compensation sources.

EP 2 637 311 B1

# FIG 4

Simple algorithm for raw DC offset calibration.

start calibration

41 — $k=0, m=0$

42 — $k=k+1, m=0$

single gain stage

43 — $m=m+1$

44 — set $A_{tot,k}$

45 — measure $DC_{RES, m}$ at ADC output

46 — calculate $DC_{comp, k, m}$ from $DC_{RES, m}$ and $A_{tot, k}$

47 — set $DC_{comp, k, m}$

48 — $m<3$ — yes

no

49 — $k<n$ — yes

no

calibration finished

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 6756924 B2
- US 7271649 B2

- US 20070184803 A1

### Non-patent literature cited in the description

- **TANAKA, T. YAMAWAKI ; K. TAKIKAWA ; N. HAYASHI ; I. OHNO ; T.WAKUTA ; S. TAKAHASHI ; M. KASAHARA ; B. HENSHAW.** GSM/DCS1800 Dual Band Direct-Conversion Transceiver IC With a DC Offset Calibration System. *01 ESSCIRC,* 2001
- **MARKO MAILAND ; HANS-JOACHIM JENT-SCHEL.** Compensation of DC-Offsets and RF-Self-Mixing Products in Six-Port-Based Analog Direct Receivers. *14th IST Mobile & Wireless Communication Summit, Dresden,* June 2005

- **RUSSELL HOPPENSTEIN.** *DC Offset Auto-Calibration of TRF371x,* 2010
- **I.-H. SOHN ; E.-R. JEONG ; Y. H. LEE.** Data-Aided Approach to I/Q Mismatch and DC Offset Compensation in Communication Receivers. *IEEE COMMUNICATIONS LETTERS,* December 2002, vol. 6 (12